**Europäisches Patentamt**

**European Patent Office**

**Office européen des brevets**

(19)

(11) **EP 1 542 026 A1**

(12) **EUROPEAN PATENT APPLICATION**

(43) Date of publication:
**15.06.2005 Bulletin 2005/24**

(51) Int Cl.[7]: **G01R 27/04**, G01R 27/06,
H03H 7/40, H04B 17/00,
H01P 5/12

(21) Application number: **03028595.1**

(22) Date of filing: **11.12.2003**

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(71) Applicant: **SIEMENS AKTIENGESELLSCHAFT
80333 München (DE)**

(72) Inventor: **Langer, Andreas
85716 Unterschleissheim-Lohhof (DE)**

Remarks:
Amended claims in accordance with Rule 86 (2)
EPC.

(54) **Method and device for determining an electromagnetic reflection coefficient of an antenna, a method and device for automatically changing the matching of a power amplifier to an antenna, and a method and a device for automatically reducing the output power of a power amplifier**

(57) Method and device for determining an electromagnetic reflection coefficient of an antenna, a method and device for automatically changing the matching of a power amplifier to an antenna, and a method and a device for automatically reducing the output power of a power amplifier.

## FIG 2

EP 1 542 026 A1

## Description

### Field of the invention

The invention relates to a method and device for determining an electromagnetic reflection coefficient of a power amplifier operating on a microwave signal. Further, the invention relates to a method and device for automatically changing the matching of an antenna or of a power amplifier operating on a microwave signal. Still further, the invention relates to a method and a device for automatically reducing the output power of a power amplifier operating on a microwave signal.

### Background of the invention

The main characterizing capabilities of an amplifier include power given for a specific load, current consumption, and also Adjacent Channel Power ACP (or sometimes referred to as Adjacent Channel Leakage Ratio ACLR). These capabilities depend on the complex load impendance which in a mobile telecommunications system is mostly defined by the antenna. Because of the continuing miniaturization of mobile terminals, the antenna volume is still being reduced. At the same time, there are nevertheless even more frequency bands to cover.

These developments have led to that the matching of an antenna is usually critical. If there is any subsequent mismatch, this can result in a very large Voltage Standing Wave Ratio VSWR. In constant envelope systems, especially in those using the GMSK modulation, the reflections following the mismatch can lead to higher current consumption, reduction of the radiated power due to "load pulling" of the power amplifier. In systems using non-constant envelope modulation, such as in UMTS where HPSK is used, the mismatch then causes an increase in adjacent channel power. To prevent this, isolators are commonly used.

In the area of mobile communications, the manufacturers usually determine antenna or power amplifier matching networks for a transmitter for a range of transmitter power and frequencies already in the design phase. The antenna or power amplifier matches are then selected as a function of the transmitter power, the frequency used, current comsuption, or ACLR in non-constant envelope systems.

However, the model of using the transmitter power or frequency only for determining the load impedance is quite rough because it neglects many other factors having an impact on the complex load impedance. As a result, the fixed matching of the antenna or power amplifier may result under antenna mismatch conditions in a non-optimal electromagnetic reflection coefficient between transmitter and antenna. This then easily leads to the effects mentioned above, i.e. to higher current consumption, reduction of the radiated power, "load pulling" of the power amplifier, or to increase in adjacent channel power in systems with non-constant envelope, such as UMTS.

### Summary of the invention

Determining the electromagnetic reflection coefficient of a microwave transmitter accurately enough has been relatively difficult and has set high requirements for the measurement equipment. There is a long-existing need to find out the complex load impedance by using relatively simple methodological steps and by minimizing tedious signal processing efforts on a microwave signal.

A first objective of the invention is to bring about a method and a device for determining the electromagnetic reflection coefficient of a power amplifier operating on a microwave signal. This can be achieved with a method or device as in independent claims 1 or 6. Dependent claims 2-3 and 7-8 describe some preferred aspects of the first objective.

When the electromagnetic reflection coefficient is known, the matching of the power amplifier or of the antenna can be adapted. In non-constant envelope systems it is also possible to reduce the output power in critical load states of the power amplifier so that the system-specific requirements regarding the adjacent channel power can be fulfilled also in the presence of mismatch.

Therefore, a second objective of the invention is to bring about a method and a device for automatically changing the matching of an antenna or of a power amplifier operating on a microwave signal, wherein in response to receiving a parameter describing the automatically determined electromagnetic reflection coefficient of the power amplifier feeding the antenna, a new match for the antenna or power amplifier is selected from a predefined set of parameters describing electromagnetic reflection coefficients - match pairs. The new match is then set to the power amplifier or antenna, respectively.

The second objective can be achieved with a method or device as in independent claims 4 or 9.

A third objective is to bring about a method and a device for automatically reducing the output power of a power amplifier operating on a microwave signal when a critical load states of the power amplifier is encountered.

The third objective can be achieved with a method or device as in independent claims 5 or 10.

**Advantages of the invention**

By using the method or device according to the first objective of the invention, a parameter describing the electromagnetic reflection coefficient $\Gamma_L$ of the load impedance of a power amplifier operating on a microwave signal can be found out. The method comprises relatively simple steps only. Especially, coherent demodulation is not necessary for finding the electromagnetic reflection coefficient.

Efficient determination means in this context that the determination of the magnitude and phase of the electromagnetic reflection coefficient $\Gamma_L$ is possible using typical hardware components used in a mobile terminal, i.e. the method is computationally not too demanding.

By using the method or device according to the second objective of the invention, some of the negative effects caused by reflections due to antenna mismatch, i.e. higher current consumption or reduction of the radiated power due to load pulling can at least partially be alleviated or avoided.

By using the method or device according to the third objective of the invention, it is possible to fulfill system-specific requirements regarding the adjacent channel power also in the presence of antenna or power amplifier mismatch.

**Short description of the drawings**

In the following, the invention is described in more detail with reference to the examples shown in Figures 2 to 5 of the accomplished drawings, of which:

Figure 1        shows some functional blocks of a mobile terminal 10 that are relevant for transmitting;

Figure 2        shows a block diagram of a microwave transmitter for which the parameter describing the electromagnetic reflection coefficient is determined and it is used for explaining the theoretical background of the invention;

Figure 3        is a block diagram illustrating the part of the central unit which takes one of the functions of the determining the electro magnetic reflection coefficient $F_L$; automatically changing the macth of the antenna or of the power amplifier; and/or automatically reducing the output power of the power amplifier.

Figure 4        is a flow chart showing the steps in compating the electromagnetic reflection coefficient $IF_L$; and

Figures 5A-5E        show some look-up-tables reducing the compatational effort in the mobile terminal when determining the electromagnetic reflection coefficient $r_L$.

**Detailed description of the invention**

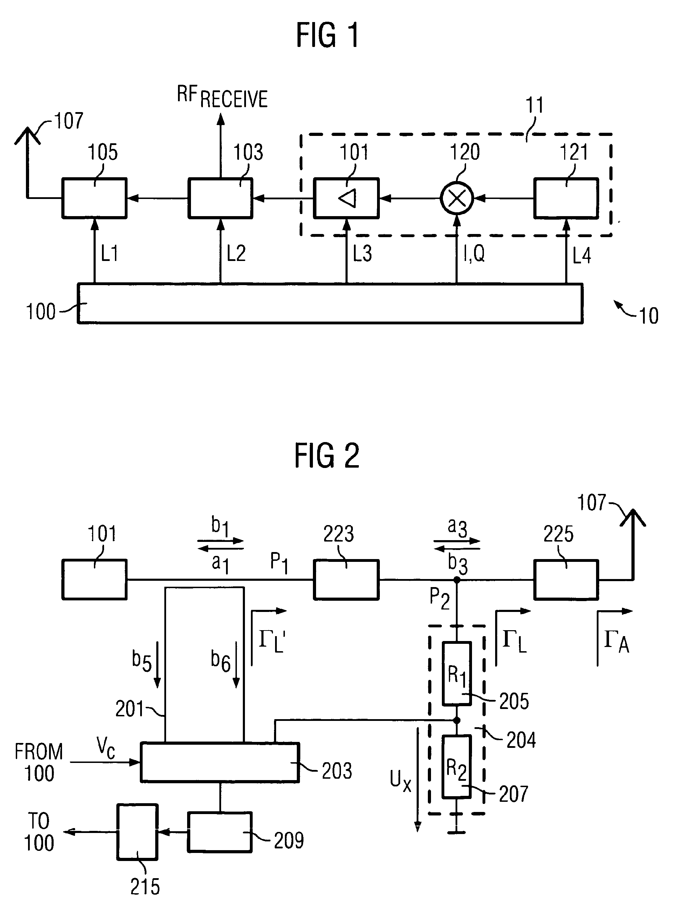

Figure 1 shows some functional blocks of a mobile terminal 10 that are relevant for transmitting. The central unit 100 controls the transmitter 11 which transmits data through an antenna 107. Between the antenna 107 and the transmitter 11 there is a matching element 105 and a front end 103 which separates downlink signals from uplink signals, and may comprise filters. The main functional components of the transmitter 11 are further expanded in more detail.

The transmitter comprises a Phase Locked Loop PLL 121 which further comprises a Voltage Controlled Oscillator. The PLL 121 is used to produce a radio frequency signal to which data signal is then multiplexed at a multiplexer 120. Usually the data signal comprises in-phase and in-quadrature components (I and Q) which depend on the modulation used. The multiplexed signal is fed to a power amplifier 101.

The central unit 100 controls the operation of the transmitter 11 through different control channels of which L3 and L4 are shown in Figure 1. Further, the central unit 100 controls the operation of the matching element 105 through control channel L1, and of the front end 103 through control channel L2.

Control channel L1 is used for selecting the match of the matching circuit 111 for the antenna 113. Control channel L2 is used for selecting the suitable filters, Control channel L3 is used for defining the ramp shape, power level, and switch signal of the power amplifier 109. Control channel L4 provides the PLL 121 with a control voltage of the VCO.

Figure 2 shows a block diagram of a microwave transmitter for which the parameter describing the electromagnetic reflection coefficient is determined and it is used for explaining the theoretical background of the invention.

The determination of the electromagnetic reflection coefficient $\Gamma_L$ comprises the steps of detecting at a first

point $P_1$ between the power amplifier 101 and the antenna 107 a first coupling voltage $b_5$ caused by a forward-propagating wave $b_1$, and a second coupling voltage $b_6$ caused by a reflected wave $a_1$. The first and second coupling voltages $b_5$ and $b_6$ are preferably obtained by using a coupler 201.

The coupler 201 is only for separating the incident and reflected wave; the measurement itself is done with detecting means 209.

The coupler 201 is preferably connected from its both ends to a switching element 203. The switching element 203 comprises three separate switches or one three-state switch. The control voltage $V_c$ controlling the position of the switch or switches is preferably obtained from the central unit 100.

The switching element 203 connects the coupler 201 to a detecting means 209, such as a Schottky-diode intended to deliver the magnitude of the voltage of the incident or reflected wave as the first and second coupling voltages $b_5$ and $b_6$, respectively.

The output of the detecting means 209 is first passed to an Analog-to-Digital Converter ADC 215. The ADC 215 converts the output of the detecting means 209 to a digital value. The digital value obtained from the ADC 215 is passed to the central unit 100.

A third voltage $U_x$ is measured at a second point $P_2$ between the power amplifier 101 and the antenna 107. For measuring the third voltage $U_x$ preferably a voltage divider 204 is used. The voltage divider 204 comprises e.g. two known resistances $R_1$ and $R_2$. If the resistances $R_1$ and $R_2$ are suitably selected, the third voltage $U_x$ obtained at the second point $P_2$ can be passed to the switching element 203 and from there, depending on the position of the switch or switches in the switching element 203, to the detecting means 209 and then to the ADC 215. The ADC 215 output is as above passed then to the central unit 100.

Instead of using the switching element 203, a larger number of detectors 209 can be used. However, by making the measurements after each other, one ADC 215 will suffice. This helps in reducing the manufacturing cost of the mobile terminal 10.

The theoretical model underlying the measurements is shortly described in the following. For simplicity, it is assumed that the measurement arrangements for outgoing and reflected waves are made without causing reflections, and that the insertion loss in the coupler 201 can be neglected.

The coupling factors for the coupler 201 are $\mathbf{a_k}'$ for an outgoing wave, $\mathbf{a_k}''$ for a reflected wave; and the isolation factors for the coupler 201 are $\mathbf{a_l}'$ for an outgoing wave, and $\mathbf{a_l}''$ for a reflected wave.

First network 223 denotes circuitry between the first point $P_1$ and the second point $P_2$. Second network 225 denotes circuitry between the second point $P_2$ and antenna 107. Depending on the structure of the voltage divider 204, the first and second networks 223, 225 may comprise different components. The first and the second point $P_1$, $P_2$ are along the transmission line between the power amplifier 101 and the antenna 107.

For example, if the second point $P_2$ is behind the front end 103, the first network 223 corresponds essentially the front end 103, and the second network 225 the antenna match 105.

If the second point $P_2$ is located directly after the first point $P_1$, then the first network 223 denotes the connection between the first point $P_1$ and the second point $P_2$, and the second network 225 corresponds in this case the front end 103 and the antenna match 105.

The electromagnetic reflection coefficient $\Gamma_L'$ at the first point $P_1$ can be written as a function of the electromagnetic reflection coefficient $\Gamma_L$ at the second point $P_2$:

$$\Gamma_L' = s_{11} + \frac{s_{12}s_{21}\Gamma_L}{1 - s_{22}\Gamma_L} \tag{1}$$

where the electromagnetic reflection coefficient $\Gamma_L$ at the second point $P_2$ is

$$\Gamma_L = s_{33} + \frac{s_{34}s_{43}\Gamma_A}{1 - s_{44}\Gamma_A} \tag{1a},$$

wherein the electromagnetic reflection coefficient of the antenna 107 has been denoted with $\Gamma_A$. $s_{11}$, $s_{12}$, $s_{21}$, $s_{22}$ are the scattering matrix parameters at the first point $P_1$, and $s_{33}$, $s_{34}$, $s_{43}$, $s_{44}$ are the scattering matrix parameters at the second point $P_2$. They can be obtained by measuring.

The outgoing wave $b_1$ and reflected wave $a_1$ can both be expressed as functions of the source reflection coefficient $\Gamma s$ and the electromagnetic reflection coefficient $\Gamma_L'$ at the first point $P_1$.

$$b_1 = \frac{b_s}{1 - \Gamma_S \Gamma_L'} \tag{2}$$

and

$$a_1 = \frac{b_s \Gamma_L'}{1 - \Gamma_S \Gamma_L'} \tag{3}$$

where $b_s$ denotes a normalized incident source wave

Using the coupling parameters the following equations can be written for the first and the second coupling voltages $b_5$ and $b_6$ i.e. the coupling voltages representing the outgoing and reflected waves $b_1$, $a_1$ at the first point $P_1$:

$$b_5 = a_K' \frac{b_s}{1 - \Gamma_S \Gamma_L'} + a_I' \frac{b_s \Gamma}{\Gamma_L'} \frac{1}{1 - \Gamma_S \Gamma_L'} \tag{4}$$

and

$$b_6 = a_I'' \frac{b_s}{1 - \Gamma_S \Gamma_L'} + a_K'' \frac{b_s \Gamma_L'}{1 - \Gamma_S \Gamma_L'} \tag{5}$$

The ratio of the first and the second coupling voltages $b_5$ and $b_6$ is the measured reflection coefficient $\Gamma_M$ which can be rewritten:

$$\Gamma_M = \frac{b_5}{b_6} = \frac{a_I'' \dfrac{b_s}{1 - \Gamma_S \Gamma_L'} + a_K'' \dfrac{b_s \Gamma_L'}{1 - \Gamma_S \Gamma_L'}}{a_K' \dfrac{b_s}{1 - \Gamma_S \Gamma_L'} + \dfrac{b_s \Gamma_L'}{1 - \Gamma_S \Gamma_L'}} = \frac{a_K'' \Gamma_L' + a_I''}{a_K' + a_I' \Gamma_L'} \tag{6}$$

from which the reflection coefficient $\Gamma_L'$ at the first point $P_1$ can be solved:

$$\Gamma_L' = \frac{a_K' \Gamma_M - a_I''}{a_K'' - a_I' \Gamma_M} \tag{7}$$

As can be seen, the measured reflection coefficient $\Gamma_M$ is independent of the source reflection coefficient $\Gamma_S$. This is important because the source reflection coefficient $\Gamma_S$ is unknown and variates during the use depending e.g. on temperature and output power. The measured reflection coefficient $\Gamma_M$ is independent of the incident source wave $b_s$, i.e. variations in the transmitting power do not effect the measured reflection coefficient $\Gamma_M$

The coupling parameters $a_K'$, $a_K''$, $a_I'$, and $a_I''$ can be determined by measurements for a specific coupler 201 type. The electromagnetic reflection coefficient $\Gamma_L'$ at the first point $P_1$ can be computed from the measured reflection coefficient $\Gamma_M$, or by using the first and second coupling voltages $b_5$ and $b_6$.

In the example shown in Figure 2, the measurements of the first and second coupling voltages $b_5$ and $b_6$ were carried out by using detector 209 only. In this manner, the output carries information about the magnitude of the first and second coupling voltages $b_5$ and $b_6$ only. From the vectoral network analysis it is known that for error correction (e.g. when calibrating a network analyzer) the magnitude and phase of the measured reflection coefficient $\Gamma_M$ are necessary.

Because now one has only the magnitude of the measured reflection coefficient $\Gamma_M$ available, in the estimation of the magnitude of the electromagnetic reflection coefficient $\Gamma_L'$ at the first point $P_1$, some systematical error is introduced which is the larger the more the phase of the electromagnetic reflection coefficient $\Gamma_L'$ at the first point $P_1$ differs from 0. In order to avoid this systematical error, some additional measures are necessary. These are explained in more detail below.

The phase of the electromagnetic reflection coefficient is detected by using the third voltage $U_x$ obtained from the voltage divider 204.

For the high frequency voltage U at the voltage divider 204 holds:

$$U = \sqrt{Z}(a_3 + b_3) = \sqrt{Z}a_3(1 + \Gamma_L) \tag{8}$$

As can be seen, the high frequency voltage U depends from the magnitude and phase of the reflection coefficient $\Gamma_L$ at the second point $P_2$.

For the third voltage $U_x$ holds:

$$U_x = \sqrt{Z}a_3(1 + \Gamma_L)T \tag{9},$$

where $T = R_2/(R_1+R_2)$.

The electromagnetic reflection coefficient $\Gamma_L$ at the second point $P_2$ can be expressed as a function of the electromagnetic reflection coefficient $\Gamma_L'$ at the first point $P_1$ [see Eq. (1)]:

$$\Gamma_L = \frac{s_{11} - \Gamma_L'}{s_{11}s_{22} - s_{12}s_{21} - s_{22}\Gamma_L'} \tag{10},$$

which can be substituted into Eq. (9) yielding:

$$U_x = \sqrt{Z}a_3\left(1 + \frac{s_{11} - \Gamma_L'}{s_{11}s_{22} - s_{12}s_{21} - s_{22}]\Gamma_L'}\right)T \tag{11}$$

$S_{11},S_{12},S_{21},S_{22}$ are known from measurements.

Because the third voltage $U_x$ depends on the magnitude and phase of the electromagnetic reflection coefficient $\Gamma_L'$ at the first point $P_1$, and because the magnitude of the electromagnetic reflection coefficient $\Gamma_L'$ at the first point $P_1$ is known, by using the third voltage $U_x$ and Eq. (11), the phase of the reflection coefficient $\Gamma_L'$ at the first point $P_1$ can be computed.

This is shortly explained referring to Eq. (9). Actually, Eq. (11) should be used, but because it is tedious to write it out in a different format, it can be shown that because these equations relate to each other through Eq. (9), it is not necessary.

Rewriting Eq. (9) yields:

$$\frac{U_x}{\sqrt{Z}a_3 T} = H = (1 + \Gamma_L) \tag{12}$$

where H is a short hand notation only.

By squaring Eq. (12) and substituting the magnitude of the reflection coefficient $\Gamma_L$ at the second point $P_2$, its phase (here denoted with $\phi$) can be obtained by first multiplying with its complex conjugate and then solving:

$$\cos\varphi = \frac{|H|^2 - 1 - |\Gamma_L|^2}{2|\Gamma_L|} \tag{13}.$$

Equation (11) can be rewritten in a signifigantly simpler form when the first network 223 is well matched, i.e. $|s11| = |s22| \cong 0$. In practice, this is almost always the case.

The magnitude of the outgoing wave $a_3$ in Eq. (12) can be expressed using the first coupling voltage $b_5$, which has to be calculated by using the approximation for the magnitude of the electromagnetic reflection coefficient $\Gamma_L'$ at the first point $P_1$ as follows:

$$a_3 = \frac{s_{21}b_5}{a_K'(1 - s_{22}\dfrac{s_{11} - \Gamma_L'}{s_{11}s_{22} - s_{12}s_{21} - s_{22}\Gamma_L'})(1 + \dfrac{a_I'}{a_K'}\Gamma_L')} \tag{11a}$$

In the determination of electromagnetic reflection coefficient $\Gamma_L'$ at the first point $P_1$ using Eq. (7), an inacceptable error can appear, if the phase of $\Gamma_L'$ deviates significantly from 0. In practice, this is very probably the case. Due to non-ideal behaviour of the coupler 201 an error is introduced in the measured electromagnetic reflection coefficient $\Gamma_M$ disturbing the determination of the magnitude of $\Gamma_L'$.

For reducing the error in the determination of the magnitude of the electromagnetic reflection coefficient $\Gamma_L'$ at the first point $P_1$, the magnitude of the electromagnetic reflection coefficient $\Gamma_L'$ at the first point is $P_1$ determined assuming an initial value for the phase. More detailed studies have shown that the initial phase has to be known with an accuracy of some ±90°. In practice, this can also under mismatch be guaranteed because the antenna 107 characteristics which usually are favourable on some phase range only, typically of ±30° which also restricts the phase range of the measured electromagnetic reflection coefficient $\Gamma_M$.

Assuming the phase, the magnitude of the electromagnetic reflection coefficient $\Gamma_L'$ at the first point is $P_1$ is determined using Eq.(7). The initial phase of the electromagnetic reflection coefficient $\Gamma_L'$ at the first point $P_1$ is then comprised in the phase of $a_k''$ and $a_i'$.

After the magnitude was determined after assuming an initial phase, in the following step the actual phase is determined using Equation (13). This phase includes naturally also an error, because the magnitude was not correctly known yet. With the phase obtained in this moment, Eq. (7) can be computed again in order to obtain an enhanced estimate to the magnitude.

In the next step an enhanced estimate of phase can be computed, and so forth. Some tests for this iterative method have shown that a single iteration step suffices to yield the magnitude and phase for the electromagnetic reflection coefficient $\Gamma_L'$ at the first point is $P_1$ the estimates having an accuracy as desired.

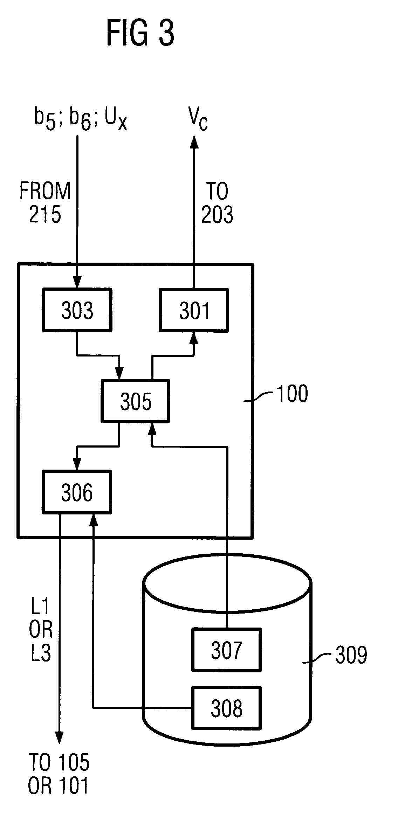

Figure 3 shows a block diagram illustrating the part of the central unit 100 taking care of the functions of: i) determining the electromagnetic reflection coefficient $\Gamma_L$ of the power amplifier 101 feeding an antenna 107 or a parameter describing it; ii) automatically changing the match 105 of the antenna 107 or of the power amplifier 101; and/or iii) automatically reducing the output power of the power amplifier 101.

The first control unit 301 of the central unit 100 controls the position of the switching element 203 by setting its control voltage $V_c$. The measurement unit 303 gets values representing coupling voltages $b_5$, $b_6$ and the detected voltage $U_x$ from the ADC 215. The measurement process is controlled by program unit 305 which controls the first control unit 301 in order to obtain the coupling voltages $b_5$, $b_6$, and the detected voltage $U_x$ from the measurement unit 303. The measurement of the three voltages is in this embodiment performed sequentially. In a mobile terminal, the measurement of one of these voltages can be performed pro burst.

In a preferred embodiment of the invention, the program unit 307 reads values stored into memory 309 in form of look-up-tables 307, performs calculations based on the coupling voltages $b_5$, $b_6$, and the detected voltage $U_x$ and, in response to these calculations, obtains a value for the electromagnetic reflection coefficient $\Gamma_L$ of the power amplifier 101 feeding an antenna 107, or a parameter describing it. The program unit 305 passes the electromagnetic reflection coefficient $\Gamma_L$, or a parameter describing it, to a second control unit 306 which takes care of adapting the match 105 of the antenna 107 or of the power amplifier 101, or reducing the output power of the power amplifier 101.

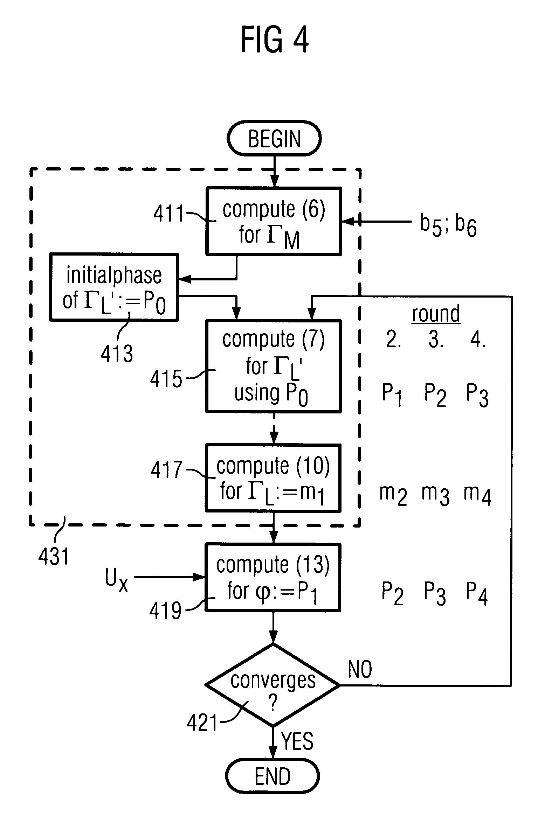

Figure 4 shows in more detail how the electromagnetic reflection coefficient $\Gamma_L$ at the second point $P_2$ can be computed.

In step 411, in response to receiving the first and the second coupling voltages $b_5$, $b_6$, the measured reflection coefficient $\Gamma_M$ can be computed by using Eq. (6). Then in step 413 an initial value $p_0$ for the phase of the electromagnetic reflection coefficient $\Gamma_L'$ at the first point $P_1$ is selected.

In step 415 the first estimate for the electromagnetic reflection coefficient $\Gamma_L'$ at the first point $P_1$ is computed using using Eq. (7) and the first estimate $p_0$.

In step 417 the first estimate $m_1$ for the electromagnetic reflection coefficient $\Gamma_L$ at the second point $P_2$ is computed using Eq. (10).

In step 419, Eq. (13) is computed using the first estimate $m_1$ for the electromagnetic reflection coefficient $\Gamma_L$ at the second point $P_2$ and the detected voltage $U_x$, obtaining a first estimate $p_1$ for the phase of the measured reflection coefficient $\Gamma_L$.

If the accuracy of the calculation is to be improved, from step 421 the processing can be returned to step 415.

The second control means 306 can be adapted so select a match 105 for the antenna 107 or the power amplier 101 as a function of the magnitude and phase of the electromagnetic reflection coefficient $\Gamma_L$ at the second

point $P_2$ or a parameter describing it. For example, the load impedance can be written as $Z = Z_0 * ( 1 + \Gamma_L ) / ( 1 - \Gamma_L )$. For this purpose, in the memory 309 there are preferably also a look-up-table 308 defining the relationship of the electromagnetic reflection coefficient $\Gamma_L$ at the second point $P_2$ (or a parameter describing it) and the selected match 105 or power level. For example, the control voltage of a varactor in the antenna match 105 can be adjusted depending when the electromagnetic reflection coefficient $\Gamma_L$ changes so that the electromagnetic reflection coefficient $\Gamma_L$ can be kept more or less constant.

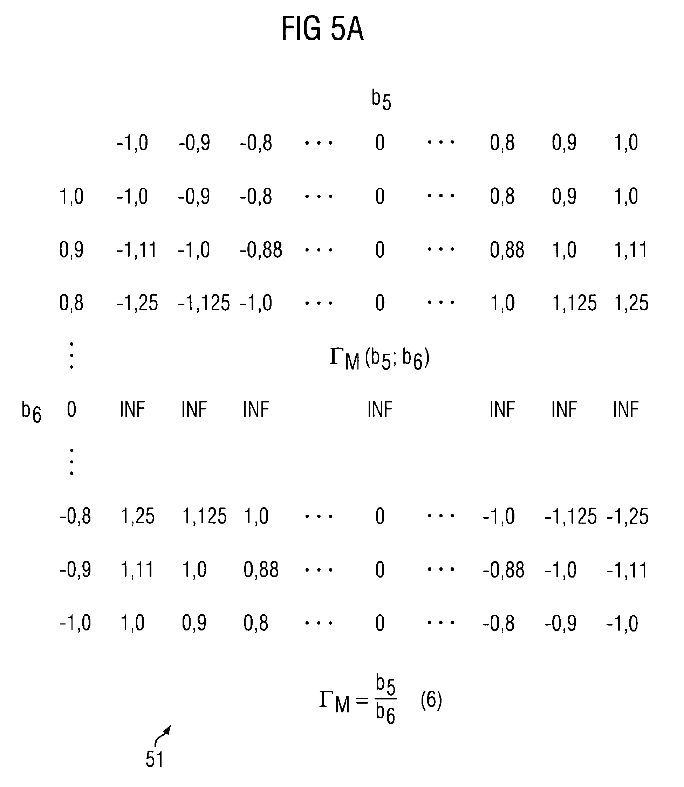

Figures 5A to 5E show how the computational effort in Figure 4 can be reduced. In Figure 5A there is a look-up-table 51 showing precalculated values of the ratios of the first and second coupling voltages $b_5$, $b_6$. This value corresponds to Eq. (6) or the measured electromagnetic reflection coefficient $\Gamma_M$. Of course, before storing the first and second coupling voltages $b_5$, $b_6$ they can be scaled by a reference value, for example, 10 mV. If a measured voltage were 1 V, a value of 100 (= 1 V / 10 mV) could be given. Using such a look-up-table would reduce the computational effort in step 411.

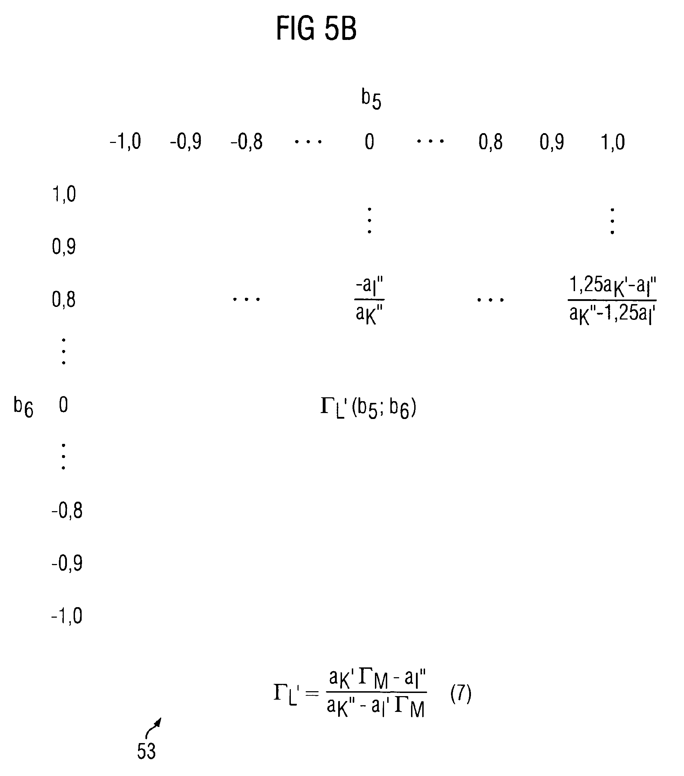

More computational effort can be saved, if instead of using look-up-table 51 a look up-table 53 as shown in Figure 5B is used. Because of Eq. (7), it can be shown that the electromagnetic reflection coefficient $\Gamma_L'$ at the first point $P_1$ is a function of the measured reflection coefficient $\Gamma_M$ and therefore a function of the first and second coupling voltages $b_5$, $b_6$ as well.

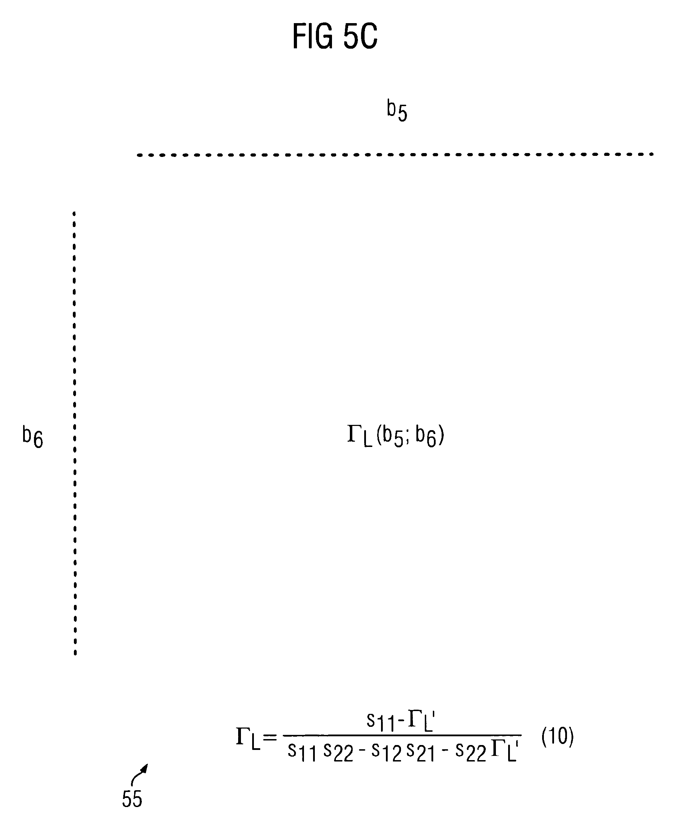

If the computational effort is to be saved even more, a look-up-table 55 as shown in Figure 5C can be used. In look-up-table 55 precalculated values for Equation (10) are stored, i.e. values for the electromagnetic reflection coefficient $\Gamma_L'$ at the second point $P_2$ as a function of the first and second coupling voltages $b_5$, $b_6$. The scattering matrix S parameters $s_{11}$, $s_{12}$, $s_{21}$ und $s_{22}$ are assumed constant. Their values can be determined in a laboratory.

An advantage of using any of the look-up tables 51, 53, or 55 is that computational time can be saved. If the look-up-table 55 is used, then steps 411, 413, 415, and 417 reduce to one step 431.

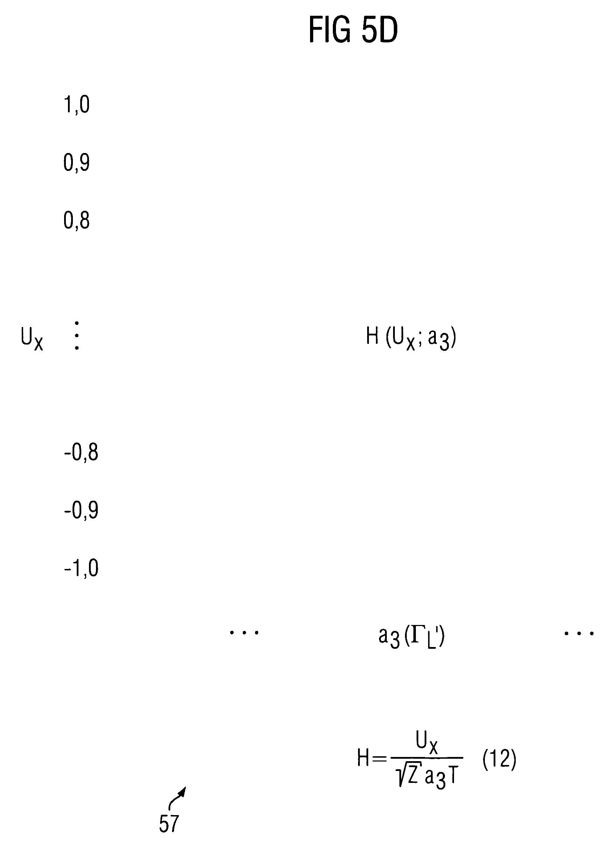

Figure 5D shows another look-up-table 57. The short hand notation H can be defined making a reference to Eq. (12), i.e. by using $U_x$ and substituting the computed values of $a_3$ using Eq. (11a) as input.

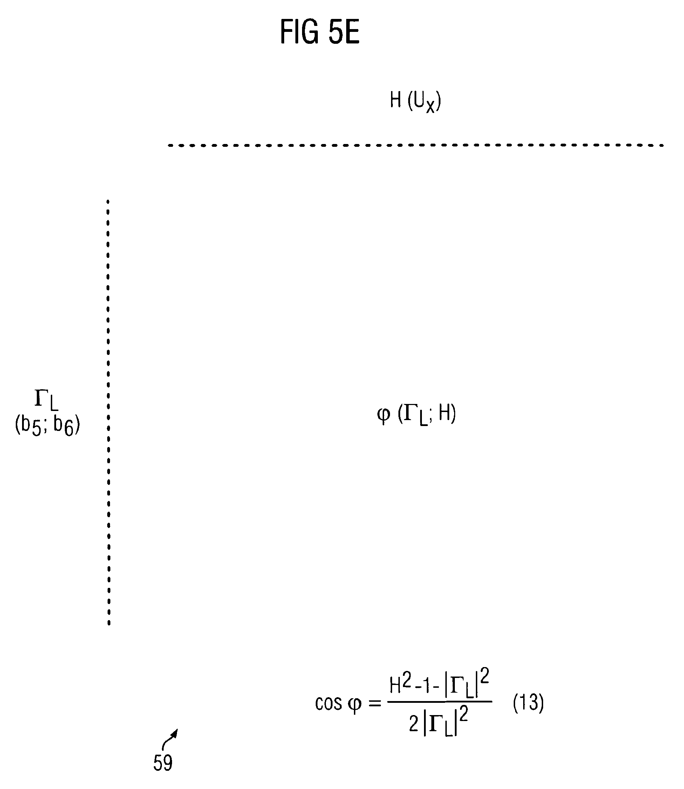

Figure 5E shows a still another look-up-table 59, comprising predefined values for phase as a function of the short hand notation $H$ and the magnitude of the electromagnetic reflection coefficient $\Gamma_L$ at the second point $P_2$ are stored as obtained by solving Eq. (13) and taking inverse cosine. By using look-up-table 59, the missing phase of the electromagnetic reflection coefficient $\Gamma_L$ at the second point $P_2$ can be determined.

All look-up-tables 51, 53, or 55, and 57, 59 are stored in the memory 309 of the mobile terminal as look-up-tables 307.

In order to enhance the results, different look-up-tables 51, 53, 55, 57, 59 can be selected from the look-up-tables 307 responsive to the frequency band to be used. For example, for the GSM 900 MHz band different look-up-tables 51 to 59 would be used than for the GSM 1800 MHz band.

If the error in the determination of the magnitude of $\Gamma_L'$ still were to be reduced, one or more further look-up-tables 59 would be necessary. The look-up-table 59 to be used were then selected depending on the phase region of the $\Gamma_L'$. The phase of the measured electromagnetic reflection coefficient $\Gamma_M$ depends on the electromagnetic reflection coefficient $\Gamma_L'$ at the first point $P_1$ [see Eq. (6)]. For different phases of the electromagnetic reflection coefficient $\Gamma_L'$ at the first point $P_1$ one can compute the measured electromagnetic reflection coefficient $\Gamma_M$ as a function of the electromagnetic reflection coefficient $\Gamma_L'$ at the first point $P_1$.

Estimates for both magnitude $m_1$, $m_2$, $m_3$, ..., and phase $p_1$, $p_2$, $p_3$, ... of the electromagnetic reflection coefficient $\Gamma_L$ at the second point $P_2$ can then be determined iteratively as shown in Figure 4. Because one look-up-table consumes very little memory, this aspect is not critical at all. We can also use Eq. (7). In this case the initial phase has to be considered in the phase of $a_k''$ and $a_i'$.

To create the look-up table 59, the electromagnetic reflection coefficient $\Gamma_L'$ at the first point $P_1$ is computed using Eq. (6) for different phase values.

An advantage brought by the measuring arrangement as shown in Figure 2 is that there is less extra switching to be performed, because the coupler 201 and detector 209 are usually available for power measurements. An ADC 215 is usually also available for battery voltage or temperature measurements. These components can now be reused for the measurement of electoromagnetic reflection coefficient or a parameter describing the electromagnetic reflection coefficient, especially of the complex impedance.

Further, in order to find out the electoromagnetic reflection coefficient or a parameter describing the electromagnetic reflection coefficient, no coherent demodulation necessary, because only the magnitude of three voltages is measured.

If the implementation is done using one or more of the look-up-tables 51 to 59, excessive computational effort in the mobile terminal can be replaced with simpler and faster tabular operations.

For each of these three voltages only one magnitude measurement is necessary. The desired complex electromagnetic reflection coefficient $\Gamma_L$ or a parameter describing the electromagnetic reflection coefficient can be calculated e.g. by using a mathematical moded already shown.

By using the described iterative method the magnitude and phase of the electromagnetic reflection coefficient $\Gamma_L$ or a parameter describing the electromagnetic reflection coefficient can be found out with a sufficient accuracy, also in the case that the coupler 201 is not ideal.

**Claims**

1. A method for determining the electromagnetic reflection coefficient ($\Gamma_L$) of a power amplifier (101) feeding an antenna (107) and operating on a microwave signal, **comprising the steps of:**

   - detecting a first coupling voltage ($b_5$) and a second coupling voltage ($b_6$) at a first point ($P_1$) along a transmission line between the power amplifier (101) and the antenna (107);
   - calculating an estimate ($m_1$) for magnitude of the electromagnetic reflection coefficient ($\Gamma_L$) at said first point ($P_1$) using said first and second coupling voltages ($b_5$, $b_6$) measured or values derived from these;
   - measuring a third voltage ($U_x$) at a second point ($P_2$) different from the first point ($P_1$), along the transmission line between the power amplifier (101) and the antenna (107), by using a voltage divider (204) comprising at least two resistors (205, 207) having known resistances ($R_1$, $R_2$);
   - calculating an estimate ($p_1$) for phase of the electromagnetic reflection coefficient ($\Gamma_L$) using said third voltage ($U_x$) measured or a value derived from it; and
   - producing a parameter describing the electromagnetic reflection coefficient ($\Gamma_L$).

2. A method according to claim 1, further **comprising the step of:** enhancing the estimate ($m_1$) for magnitude by calculating a second estimate ($m_2$) for magnitude using the estimate ($p_1$) for phase calculated.

3. A method according to claim 1 or 2, further **comprising the step of:** enhancing the estimate ($p_1$) for phase by calculating a second estimate ($p_2$) for phase using the estimate ($m_1$) for magnitude calculated.

4. A method for automatically changing the matching of an antenna (107) or of a power amplifier (101) feeding an antenna (107) and operating on a microwave signal, **comprising the steps of:**

   - receiving a parameter ($m_1$,$p_1$) describing a determined electromagnetic reflection coefficient ($\Gamma_L$) of the power amplifier (101) feeding the antenna (107);
   - responsive to the parameter ($m_1$,$p_1$) describing the automatically determined electromagnetic reflection coefficient ($\Gamma_L$), selecting a new match (105) for the antenna (107) or power amplifier (101) from a predefined set (308) of electromagnetic reflection coefficient ($\Gamma_L$) - match (105) pairs; and
   - setting the new match (105) of the antenna (107) or of the power amplifier (101).

5. A method for automatically reducing the output power of a power amplifier (101) feeding an antenna (107) and operating on a microwave signal, **comprising the steps of:**

   - receiving a parameter ($m_1$,$p_1$) describing an automatically determined electromagnetic reflection coefficient ($\Gamma_L$) of the power amplifier (101) feeding the antenna (107);
   - responsive to the parameter ($m_1$,$p_1$) describing the automatically determined electromagnetic reflection coefficient ($\Gamma_L$), selecting a new target power level for the power amplifier (101) from a predefined set (308) of parameter describing an automatically determined electromagnetic reflection coefficient ($\Gamma_L$) - target power level pairs; and
   - setting the new target power level or of the power amplifier (101).

6. A device (100, 204, 209, 215) for determining the electromagnetic reflection coefficient ($\Gamma_L$) of a power amplifier (101) feeding an antenna (107), **comprising:**

   - means (201) for detecting a first coupling voltage ($b_5$) and a second coupling voltage ($b_6$) at a first point ($P_1$) along a transmission line between the power amplifier (101) and the antenna (107);

- means (211) for calculating an estimate ($m_1$) for magnitude of the electromagnetic reflection coefficient ($\Gamma_L$) at said first point ($P_1$) using said first and second coupling voltages ($b_5$, $b_6$) measured or values derived from these;
- means (204) for measuring a third voltage ($U_x$) at a second point ($P_2$) different from the first point ($P_1$) along the transmission line, between the power amplifier (101) and the antenna (107), by using a voltage divider (204) comprising at least two resistors (205, 207) having known resistances ($R_1$, $R_2$);
- means (211) for calculating an estimate ($p_1$) for phase of the electromagnetic reflection coefficient ($\Gamma_L$) using said third voltage ($U_x$) measured or a value derived from it; and
- means (211) for producing a parameter describing the electromagnetic reflection coefficient ($\Gamma_L$) determined.

7. A device (100, 204, 209, 215) according to claim 6, further **comprising:**

   means (305) for enhancing the estimate ($m_1$) for magnitude by calculating a second estimate ($m_2$) for magnitude using the estimate ($p_1$) for phase calculated.

8. A device (100, 204, 209, 215) according to claim 6 or 7, further **comprising:**

   means (305) for enhancing the estimate ($p_1$) for phase by calculating a second estimate ($p_2$) for phase using the estimate ($m_1$) for magnitude calculated.

9. A device (306) for automatically changing the matching of an antenna (107) or of a power amplifier (101) feeding an antenna (107),
   **comprising:**

   - means (306) for receiving a parameter ($m_1$, $p_1$) describing an electromagnetic reflection coefficient ($\Gamma_L$) of the power amplifier (101) feeding the antenna (107);
   - means (306) responsive to the parameter ($m_1$, $p_1$) describing an electromagnetic reflection coefficient ($\Gamma_L$), for selecting a new match (105) for the antenna (107) or power amplifier (101) from a predefined set (308) of electromagnetic reflection coefficient ($\Gamma_L$) - match (105) pairs; and
   - means (306 L1;L3;105) for setting the new match (105) of the antenna (107) or the power amplifier (101).

10. A device (306) for automatically reducing the output power of a power amplifier (101) feeding an antenna (107) and operating on a microwave signal, **comprising:**

    - means (306) for receiving a parameter ($m_1$, $p_1$) describing the automatically determined electromagnetic reflection coefficient ($\Gamma_L$) of the power amplifier (101) feeding the antenna (107);
    - means (306) responsive to the parameter ($m_1$, $p_1$) describing the automatically determined electromagnetic reflection coefficient ($\Gamma_L$) for selecting a new target power level for the power amplifier (101) from a predefined set (308) of parameters describing electromagnetic reflection coefficients ($\Gamma_L$) - target power level; and
    - means (306; 101; L3) for setting the new target power level for the power amplifier (101).

**Amended claims in accordance with Rule 86(2) EPC.**

1. A method for automatically reducing the output power of a power amplifier (101) feeding an antenna (107) and operating on a microwave signal,
   **comprising the steps of:**

   - receiving a parameter ($m_1$, $p_1$) describing an automatically determined electromagnetic reflection coefficient ($\Gamma_L$) of the power amplifier (101) feeding the antenna (107);
   - responsive to the parameter ($m_1$, $p_1$) describing the automatically determined electromagnetic reflection coefficient ($\Gamma_L$), selecting a new target power level for the power amplifier (101) from a predefined set (308) of parameter describing an automatically determined electromagnetic reflection coefficient ($\Gamma_L$) - target power level pairs; and
   - setting the new target power level or of the power amplifier (101).

2. A method according to claim 1, further **comprising the step of:** automatically determining the electromagnetic reflection coefficient ($\Gamma_L$), by performing the steps of:

- detecting a first coupling voltage ($b_5$) and a second coupling voltage ($b_6$) at a first point ($P_1$) along a transmission line between the power amplifier (101) and the antenna (107);
- calculating an estimate ($m_1$) for magnitude of the electromagnetic reflection coefficient ($\Gamma_L$) at said first point ($P_1$) using said first and second coupling voltages ($b_5$, $b_6$) measured or values derived from these;
- measuring a third voltage ($U_x$) at a second point ($P_2$) different from the first point ($P_1$), along the transmission line between the power amplifier (101) and the antenna (107), by using a voltage divider (204) comprising at least two resistors (205, 207) having known resistances ($R_1$, $R_2$);
- calculating an estimate ($p_1$) for phase of the electromagnetic reflection coefficient ($\Gamma_L$) using said third voltage ($U_x$) measured or a value derived from it; and
- producing the parameter describing the electromagnetic reflection coefficient ($\Gamma_L$).

**3.** A method according to claim 2, **wherein:** the step of automatically determining the electromagnetic reflection coefficient ($\Gamma_L$) further **comprises the step of:** enhancing the estimate ($m_1$) for magnitude by calculating a second estimate ($m_2$) for magnitude using the estimate ($p_1$) for phase calculated.

**4.** A method according to claim 2 or 3, further **comprising the step of:** enhancing the estimate ($p_1$) for phase by calculating a second estimate ($p_2$) for phase using the estimate ($m_1$) for magnitude calculated.

**5.** A device (306) for automatically reducing the output power of a power amplifier (101) feeding an antenna (107) and operating on a microwave signal, **comprising:**

- means (306) for receiving a parameter ($m_1,p_1$) describing the automatically determined electromagnetic reflection coefficient ($\Gamma_L$) of the power amplifier (101) feeding the antenna (107);
- means (306) responsive to the parameter ($m_1,p_1$) describing the automatically determined electromagnetic reflection coefficient ($\Gamma_L$) for selecting a new target power level for the power amplifier (101) from a predefined set (308) of parameters describing electromagnetic reflection coefficients ($\Gamma_L$) - target power level; and
- means (306; 101; L3) for setting the new target power level for the power amplifier (101).

**6.** A device (306) according to claim 5, further comprising:

a device (100, 204, 209, 215) for determining the electromagnetic reflection coefficient ($\Gamma_L$) of the power amplifier (101), and comprising:

- means (201) for detecting a first coupling voltage ($b_5$) and a second coupling voltage ($b_6$) at a first point ($P_1$) along a transmission line between the power amplifier (101) and the antenna (107);
- means (211) for calculating an estimate ($m_1$) for magnitude of the electromagnetic reflection coefficient ($\Gamma_L$) at said first point ($P_1$) using said first and second coupling voltages ($b_5$, $b_6$) measured or values derived from these;
- means (204) for measuring a third voltage ($U_x$) at a second point ($P_2$) different from the first point ($P_1$) along the transmission line, between the power amplifier (101) and the antenna (107), by using a voltage divider (204) comprising at least two resistors (205, 207) having known resistances ($R_1$, $R_2$);
- means (211) for calculating an estimate ($p_1$) for phase of the electromagnetic reflection coefficient ($\Gamma_L$) using said third voltage ($U_x$) measured or a value derived from it; and
- means (211) for producing the parameter describing the electromagnetic reflection coefficient ($\Gamma_L$) determined.

**7.** A device (306) according to claim 6, **wherein:** the device (100, 204, 209, 215) for determining the electromagnetic reflection coefficient ($\Gamma_L$) further comprises:

means (305) for enhancing the estimate ($m_1$) for magnitude by calculating a second estimate ($m_2$) for magnitude using the estimate ($p_1$) for phase calculated.

**8.** A device (306) according to claim 6 or 7, **wherein:** the device (100, 204, 209, 215) for determining the electromagnetic reflection coefficient ($\Gamma_L$) further comprises: means (305) for enhancing the estimate ($p_1$) for phase by calculating a second estimate ($p_2$) for phase using the estimate ($m_1$) for magnitude calculated.

# FIG 1

# FIG 2

# FIG 3

$b_5; b_6; U_x$

$V_c$

FROM 215

TO 203

303

301

305

100

306

L1 OR L3

307

309

308

TO 105 OR 101

# FIG 4

```
                    ( BEGIN )
                        │
      ┌ ─ ─ ─ ─ ─ ─ ─ ─ │ ─ ─ ─ ─ ─ ─ ─ ┐
                        ▼
411 ─┤        ┌──────────────────┐      ◄─── b₅; b₆
      │        │  compute (6)     │
      │        │  for Γ_M         │
      │        └──────────────────┘
      │   ┌──────────────┐    │
      │   │ initialphase │◄───┘
      │   │ of Γ_L':=P₀  │
      │   └──────────────┘              round
     413       │                      2.   3.   4.
      │        ▼
415 ─┤   ┌──────────────┐
      │   │ compute (7)  │
      │   │ for Γ_L'     │             P₁   P₂   P₃
      │   │ using P₀     │
      │   └──────────────┘
      │        ▼
417 ─┤   ┌──────────────┐
      │   │ compute (10) │             m₂   m₃   m₄
      │   │ for Γ_L:=m₁  │
      │   └──────────────┘
      └ ─ ─ ─ ─│─ ─ ─ ─ ─ ─ ─ ─ ─ ─ ─ ┘
    431        ▼
         ┌──────────────┐
   U_x ─►│ compute (13) │             P₂   P₃   P₄
         │ for φ:=P₁    │
         └──────────────┘
    419       ▼
          ◇ converges ?◇ ── NO ──┐
    421       │  YES
              ▼
          ( END )
```

compute (6) for $\Gamma_M$ — 411

$b_5; b_6$

initialphase of $\Gamma_L':=P_0$ — 413

compute (7) for $\Gamma_L'$ using $P_0$ — 415

compute (10) for $\Gamma_L:=m_1$ — 417

431

$U_x$ — compute (13) for $\varphi:=P_1$ — 419

converges ? — 421 — NO — YES

round
2.   3.   4.

$P_1$   $P_2$   $P_3$

$m_2$   $m_3$   $m_4$

$P_2$   $P_3$   $P_4$

# FIG 5A

$b_5$

| | -1,0 | -0,9 | -0,8 | $\cdots$ | 0 | $\cdots$ | 0,8 | 0,9 | 1,0 |
|---|---|---|---|---|---|---|---|---|---|
| 1,0 | -1,0 | -0,9 | -0,8 | $\cdots$ | 0 | $\cdots$ | 0,8 | 0,9 | 1,0 |
| 0,9 | -1,11 | -1,0 | -0,88 | $\cdots$ | 0 | $\cdots$ | 0,88 | 1,0 | 1,11 |
| 0,8 | -1,25 | -1,125 | -1,0 | $\cdots$ | 0 | $\cdots$ | 1,0 | 1,125 | 1,25 |

$\vdots$

$$\Gamma_M(b_5; b_6)$$

| $b_6$ | 0 | INF | INF | INF | | INF | | INF | INF | INF |
|---|---|---|---|---|---|---|---|---|---|---|

$\vdots$

| | -0,8 | 1,25 | 1,125 | 1,0 | $\cdots$ | 0 | $\cdots$ | -1,0 | -1,125 | -1,25 |
|---|---|---|---|---|---|---|---|---|---|---|
| | -0,9 | 1,11 | 1,0 | 0,88 | $\cdots$ | 0 | $\cdots$ | -0,88 | -1,0 | -1,11 |
| | -1,0 | 1,0 | 0,9 | 0,8 | $\cdots$ | 0 | $\cdots$ | -0,8 | -0,9 | -1,0 |

$$\Gamma_M = \frac{b_5}{b_6} \quad (6)$$

51

# FIG 5B

$b_5$

| | -1,0 | -0,9 | -0,8 | $\cdots$ | 0 | $\cdots$ | 0,8 | 0,9 | 1,0 |

1,0

0,9

0,8 $\qquad \cdots \qquad \dfrac{-a_I''}{a_K''} \qquad \cdots \qquad \dfrac{1,25a_K'-a_I''}{a_K''-1,25a_I'}$

$b_6$  0  $\qquad \Gamma_L'(b_5;\,b_6)$

-0,8

-0,9

-1,0

$$\Gamma_L' = \frac{a_K'\,\Gamma_M - a_I''}{a_K'' - a_I'\,\Gamma_M} \quad (7)$$

53

# FIG 5C

$b_5$

$b_6$

$\Gamma_L(b_5; b_6)$

$$\Gamma_L = \frac{s_{11} - \Gamma_{L'}}{s_{11}s_{22} - s_{12}s_{21} - s_{22}\Gamma_{L'}} \quad (10)$$

55

# FIG 5D

1,0

0,9

0,8

$U_X$    $\vdots$                  $H\,(U_X;\,a_3)$

-0,8

-0,9

-1,0

$\cdots$            $a_3\,(\Gamma_L{}')$           $\cdots$

$$H = \frac{U_X}{\sqrt{Z}\,a_3 T} \quad (12)$$

57

# FIG 5E

$H\,(U_X)$

$\Gamma_L$
$(b_5;\,b_6)$

$\varphi\,(\Gamma_L;\,H)$

$$\cos \varphi = \frac{H^2 - 1 - |\Gamma_L|^2}{2\,|\Gamma_L|^2} \quad (13)$$

59

## EP 1 542 026 A1

**European Patent Office**

## EUROPEAN SEARCH REPORT

**Application Number**

EP 03 02 8595

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 4 489 271 A (RIBLET GORDON P) 18 December 1984 (1984-12-18) * the whole document * --- | 1-3,6-8 | G01R27/04 G01R27/06 H03H7/40 H04B17/00 |
| X | SU 1 596 277 A (GO POLT INST) 30 September 1990 (1990-09-30) * figure * * abstract * --- | 1-3,6-8 | H01P5/12 |
| A | DE 34 10 730 A (LICENTIA GMBH) 26 September 1985 (1985-09-26) * page 4, line 6 - page 5, line 9 * * figures 1-3 * * abstract * --- | 1-3,6-8 | |
| A | US 4 015 223 A (CHEZE RENE) 29 March 1977 (1977-03-29) * column 2, line 9 - column 3, line 33 * * figure 1 * * abstract * --- | 1-3,6-8 | |
| A | DE 31 11 204 A (STUMPER ULRICH DR RER NAT DIPL) 30 September 1982 (1982-09-30) * page 2, line 1 - page 5, line 24 * * figure * * abstract * --- | 1-3,6-8 | TECHNICAL FIELDS SEARCHED (Int.Cl.7) G01R H03H H01P H04B |
| A | MARTIUS S: "RECHNERGESTUTZTE REFLEXIONSFAKTORMESSUNG - THEORIE UND ANWENDUNG" FREQUENZ, SCHIELE UND SCHON GMBH. BERLIN, DE, vol. 42, no. 4, 1 April 1988 (1988-04-01), pages 121-124, XP000006309 ISSN: 0016-1136 * the whole document * --- -/-- | 1-3,6-8 | |

The present search report has been drawn up for all claims

| Place of search | Date of completion of the search | Examiner |
|---|---|---|
| MUNICH | 21 April 2004 | von Walter, S-U |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 1 542 026 A1

| | European Patent Office | EUROPEAN SEARCH REPORT | Application Number EP 03 02 8595 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 1 041 723 A (NOKIA MOBILE PHONES LTD) 4 October 2000 (2000-10-04) * column 4, line 32 - column 8, line 16 * | 4,9 | |
| Y | * column 13, line 33 - line 44 * * figure 2 * * abstract * --- | 5,10 | |
| A | WO 96/39727 A (FLASH COMM INC) 12 December 1996 (1996-12-12) * page 3, line 4 - page 4, line 36 * * page 6, line 2 - page 8, line 9 * * page 9, line 21 - page 10, line 11 * * figure 1 * * abstract * --- | 4,5,9,10 | |
| Y | EP 0 047 354 A (BOSCH GMBH ROBERT) 17 March 1982 (1982-03-17) * page 5, line 16 - line 26 * * figure * ----- | 5,10 | |

TECHNICAL FIELDS
SEARCHED    (Int.Cl.7)

The present search report has been drawn up for all claims

| Place of search MUNICH | Date of completion of the search 21 April 2004 | Examiner von Walter, S-U |
|---|---|---|

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

European Patent
Office

**Application Number**

EP 03 02 8595

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

**LACK OF UNITY OF INVENTION**
**SHEET B**

The Search Division considers that the present European patent application does not comply with the requirements of unity of invention and relates to several inventions or groups of inventions, namely:

1. Claims: 1-3,6-8

   Method and device for determining an electromagnetic reflection coefficient of an antenna

2. Claims: 4,9

   Method and device for automatically changing the matching of a power amplifier to an antenna

3. Claims: 5,10

   Method and device for automatically reducing the output power of a power amplifier

**ANNEX TO THE EUROPEAN SEARCH REPORT
ON EUROPEAN PATENT APPLICATION NO.**                    EP 03 02 8595

This annex lists the patent family members relating to the patent documents cited in the above-mentioned European search report.
The members are as contained in the European Patent Office EDP file on
The European Patent Office is in no way liable for these particulars which are merely given for the purpose of information.

21-04-2004

| Patent document cited in search report | | Publication date | Patent family member(s) | | Publication date |
|---|---|---|---|---|---|
| US 4489271 | A | 18-12-1984 | CA<br>GB | 1137554 A1<br>2040478 A ,B | 14-12-1982<br>28-08-1980 |
| SU 1596277 | A | 30-09-1990 | SU | 1596277 A1 | 30-09-1990 |
| DE 3410730 | A | 26-09-1985 | DE | 3410730 A1 | 26-09-1985 |
| US 4015223 | A | 29-03-1977 | FR<br>DE<br>GB<br>IT<br>NL | 2298903 A1<br>2601869 A1<br>1519672 A<br>1053349 B<br>7600597 A | 20-08-1976<br>29-07-1976<br>02-08-1978<br>31-08-1981<br>26-07-1976 |
| DE 3111204 | A | 30-09-1982 | DE | 3111204 A1 | 30-09-1982 |
| EP 1041723 | A | 04-10-2000 | FI<br>EP | 990687 A<br>1041723 A2 | 30-09-2000<br>04-10-2000 |
| WO 9639727 | A | 12-12-1996 | US<br>AU<br>WO | 5589844 A<br>5871096 A<br>9639727 A1 | 31-12-1996<br>24-12-1996<br>12-12-1996 |
| EP 0047354 | A | 17-03-1982 | DE<br>EP | 3033407 A1<br>0047354 A1 | 22-04-1982<br>17-03-1982 |

EPO FORM P0459

For more details about this annex : see Official Journal of the European Patent Office, No. 12/82